(19) **Europäisches Patentamt / European Patent Office / Office européen des brevets**

(11) **EP 4 600 973 A1**

(12) **EUROPEAN PATENT APPLICATION**
published in accordance with Art. 153(4) EPC

(43) Date of publication:
**13.08.2025 Bulletin 2025/33**

(21) Application number: **23874916.2**

(22) Date of filing: **04.10.2023**

(51) International Patent Classification (IPC):
*H01B 3/00* (2006.01)   *B32B 15/082* (2006.01)
*B32B 15/20* (2006.01)   *B32B 27/30* (2006.01)
*C08K 3/013* (2018.01)   *C08K 7/18* (2006.01)
*C08L 27/12* (2006.01)   *H05K 1/03* (2006.01)

(52) Cooperative Patent Classification (CPC):
**B32B 15/082; B32B 15/20; B32B 27/30;
C08J 5/18; C08K 3/013; C08K 3/22; C08K 3/34;
C08K 3/36; C08K 7/00; C08K 7/18; C08L 27/12;
C08L 27/18; C08L 101/00; H01B 3/00; H01B 3/44;**
(Cont.)

(86) International application number:
**PCT/JP2023/036266**

(87) International publication number:
**WO 2024/075791 (11.04.2024 Gazette 2024/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.10.2022 JP 2022162085**

(71) Applicant: DAIKIN INDUSTRIES, LTD.
**Osaka-shi, Osaka 530-0001 (JP)**

(72) Inventors:
 • UEDA, Yuki
  **Osaka-shi, Osaka 530-0001 (JP)**
 • OKUNO, Shingo
  **Osaka-shi, Osaka 530-0001 (JP)**
 • SAWAKI, Kyohei
  **Osaka-shi, Osaka 530-0001 (JP)**
 • HOSOKAWA, Moe
  **Osaka-shi, Osaka 530-0001 (JP)**
 • TANAKA, Yoshito
  **Osaka-shi, Osaka 530-0001 (JP)**
 • YAMAUCHI, Akiyoshi
  **Osaka-shi, Osaka 530-0001 (JP)**
 • KISHIKAWA, Yosuke
  **Osaka-shi, Osaka 530-0001 (JP)**

(74) Representative: Hoffmann Eitle
**Patent- und Rechtsanwälte PartmbB
Arabellastraße 30
81925 München (DE)**

(54) **DIELECTRIC AND METHOD OF MANUFACTURING SAME**

(57) A dielectric that reduces frequency dependency of a dielectric constant in terahertz high-frequency bands (110 to 330 GHz) of the dielectric constant and a method for producing the same, are provided. The dielectric having a slope of a dielectric constant (Dk) with respect to frequencies from 220 GHz to 330 GHz of 0.00001 or more and 0.0005 or less, as measured with a Fabry-Perot resonator J-band.

**EP 4 600 973 A1**

**(Cont. next page)**

(52) Cooperative Patent Classification (CPC): (Cont.)
     **H05K 1/03**

**Description**

Technical Field

This disclosure relates to a dielectric and a method for producing the same.

Background Art

In high-frequency printed wiring boards, those with a low transmission loss have been demanded. In such high-frequency printed wiring boards, fluororesin films are publicly known to be used (Patent Literature 1 and the like). Moreover, Patent Literatures 2 and 3 describe the use of fluororesins compounded with a filler as wiring board materials.
Furthermore, Patent Literature 4 discloses the use of a fluororesin composition in which a fluororesin has been compounded with spherical silica particles is used for a circuit board.

Citation List

Patent Literature

[Patent Literature 1] Japanese Patent Laid-Open No. 2015-8260
[Patent Literature 2] Japanese Patent Laid-Open No. 63-259907
[Patent Literature 3] Japanese Translation of PCT International Application Publication No. 2022-510017
[Patent Literature 4] International Publication No. WO2020/145133

Summary of the Invention

Technical Problem

An object of the present disclosure is to obtain a dielectric that reduces frequency dependency of a dielectric constant in terahertz high-frequency bands (110 to 330 GHz) and a method for producing the same.
Moreover, the object of the present disclosure is to provide a dielectric with a small anisotropy of a dielectric constant and a method for producing the same.
Furthermore, the object of the present disclosure is to provide a dielectric with a small dielectric loss tangent in high-frequency bands and a method for producing the same.

Solution to Problem

The present disclosure is a dielectric characterized in that the dielectric has a slope of a dielectric constant (Dk) with respect to frequencies from 220 GHz to 330 GHz of 0.00001 or more and 0.0005 or less, as measured with a Fabry-Perot resonator J-band.
The present disclosure is also a dielectric characterized in that the dielectric has a 90° anisotropy of a dielectric constant (Dk) in the planar direction of the dielectric at 170 GHz of 0.02 or less, as measured with a Fabry-Perot resonator J-band.
The present disclosure is also a dielectric characterized in that the dielectric has a dielectric loss tangent (Df) at 220 GHz of 0.00153 or less, as measured with a Fabry-Perot resonator J-band.
The present disclosure is also a dielectric characterized in that the dielectric has a dielectric loss tangent (Df) at 330 GHz of 0.00165 or less, as measured with a Fabry-Perot resonator J-band.
The dielectric preferably contains a resin and a spherical filler.
The filler is preferably at least one selected from the group consisting of silica, titanium oxide, alumina, and forsterite.
The filler is preferably spherical silica singly.
The filler preferably has an average particle size of 0.1 to 10 $\mu$m.
The resin is preferably a fluororesin.
It is preferable that the fluororesin is partially or totally at least one polymer selected from the group consisting of a polytetrafluoroethylene resin, a tetrafluoroethylene-perfluoroalkylvinylether copolymer, and a tetrafluoroethylene-hexafluoropropylene copolymer.
The dielectric is preferably obtained by using a fluororesin particle having a primary particle size of 0.05 to 10 $\mu$m

as a raw material.

The fluororesin particle preferably has a particle size at a cumulative volume of 50% of 0.05 to 40 μm.

The dielectric is preferably used for a terahertz-band printed circuit board, a terahertz-band dielectric material, or a terahertz-band laminate circuit board.

The dielectric preferably has a sheet shape.

The present disclosure is also a method for producing the aforementioned dielectric, characterized by having a step of mixing a fluororesin particle and a filler to form a film.

The method for producing the dielectric preferably includes mixing only a fluororesin particle and a filler to form a film without addition of other components.

The present disclosure is also a copper-clad laminate having copper foil and the aforementioned dielectric as essential layers.

The present disclosure is also a circuit board characterized by having the copper-clad laminate described above.

Advantageous Effects of Invention

The dielectric of the present disclosure can reduce frequency dependence of the dielectric constant in terahertz high-frequency bands.

Moreover, the anisotropy of the dielectric constant can be reduced.

Furthermore, a dielectric loss tangent in high-frequency bands can be reduced.

Description of embodiments

The present disclosure will be described in detail below.

In recent years, with an increase in frequency of electronic products, wiring boards are also required to have performance that corresponds to high frequencies.

Firstly, it is not preferable for the dielectric constant to vary with a frequency in high frequency bands. Such a dielectric when formed into a copper-clad laminate necessitates changing a wiring width of copper wiring for each frequency, resulting in complicated wiring. Moreover, in a case in which the wiring width cannot be changed, the dielectric can only be used at a specific frequency.

Thus, in order to prevent such a situation from occurring, it is necessary to obtain a dielectric having small frequency dependence of the dielectric constant.

Secondly, it is desired to obtain a dielectric having a small anisotropy of the dielectric constant in high-frequency bands.

It is not preferable in that when formed into a copper-clad laminate, a dielectric with the anisotropic dielectric constant necessitates changing a wiring width of copper wiring depending on its direction in a case in which it is designed to have other than a straight line.

Furthermore, the dielectric preferably has a low dielectric loss tangent (Df) for each frequency of 220 GHz and 330 GHz. Since the dielectric of a fluororesin is used for the purpose of obtaining a low transmission loss material with a small transmission loss of high-frequency signals, by using a dielectric with a low dielectric loss tangent, the dielectric preferably has a small dielectric loss tangent value. In the present disclosure, an object thereof is to obtain a dielectric having these properties.

(Frequency dependence of dielectric constant)

The first dielectric of the present disclosure has a slope of a dielectric constant (Dk) with respect to frequencies from 220 GHz to 330 GHz of 0.00001 or more and 0.0005 or less, as measured with a Fabry-Perot resonator J-band.

Namely, this means that the frequency dependence of the dielectric constant in the high frequency bands is small.

In the present disclosure, the dielectric constant (Dk) and dielectric loss tangent (Df) have been measured at each frequency using a network analyzer (N5290a, manufactured by Keysight Technologies Inc.) and a Fabry-Perot resonator (manufactured by EM Labs, Inc.) under conditions of room temperature of 25°C and humidity of 50%.

Furthermore, the slope of the dielectric constant was calculated by plotting the values of the dielectric constant from 220 GHz to 330 GHz.

The above-described slope of 0.00001 or more and 0.0005 or less does not necessitate changing a wiring width of copper wiring for each frequency when a dielectric is formed into a copper-clad laminate, and enables it to be used over a wide range of frequencies. The above-described upper limit is more preferably 0.0004 and still more preferably 0.0002.

(Anisotropy of dielectric constant)

The second dielectric of the present disclosure has a 90° anisotropy of the dielectric constant (Dk) in the planar direction of the dielectric at 170 GHz of 0.02 or less.

In other words, this means that the anisotropy of the dielectric constant in the high frequency band is small.

Furthermore, the 90° anisotropy of the dielectric constant in the planar direction is obtained by measuring dielectric constants (Dk) at 0° and 90° in the planar direction of the dielectric at 170 GHz using a network analyzer (N5290A, manufactured by Keysight Technologies Inc.) and a Fabry-Perot resonator (manufactured by EM Labs, Inc.) under conditions of room temperature of 25°C and humidity of 50%, and calculating the difference thereof.

The anisotropy of 0.02 or less is preferred, taking into account that there is no need to change a wiring width of copper wiring depending on its direction in a case in which it is designed to have other than a straight line. The upper limit is more preferably 0.018 and still more preferably 0.016.

(Dielectric loss tangent (Df) at 220 GHz)

The third dielectric of the present disclosure has a dielectric loss tangent of 0.00153 or less at 220 GHz. That is, the dielectric having such a dielectric loss tangent has the effect of a low loss, i.e., a low transmission loss of high frequency signals. The upper limit is more preferably 0.00152 and still more preferably 0.00151. The lower limit of the Df is not limited, but is more preferably 0.

It is to be noted that the dielectric loss tangent as used herein has been measured using a network analyzer (N5290A, manufactured by Keysight Technologies Inc.) and a Fabry-Perot resonator (manufactured by EM Labs, Inc.) under conditions of room temperature of 25°C and humidity of 50%.

(Dielectric loss tangent (Df) at 330 GHz)

The fourth dielectric of the present disclosure has a dielectric loss tangent of 0.00165 or less. That is, the dielectric having such a dielectric loss tangent has the effect of a low loss, i.e., a low transmission loss of high frequency signals. The above-described upper limit is more preferably 0.00164 and still more preferably 0.00163. The lower limit of the Df is not limited, but is more preferably 0.

The dielectric of the present disclosure may have any one of the first to fourth properties described above, may have two or more properties, or may have all of the properties.

(Dielectric)

The dielectric of the present disclosure is not limited as long as it satisfies any of the aforementioned parameters, but is preferably a composition containing a spherical filler and a fluororesin. In such a composition, the composition can be adjusted, if necessary to produce a dielectric that satisfies the aforementioned parameters. The spherical filler and fluororesin that can be used in such a dielectric will be described in detail below.

(Fluororesin)

The fluororesin sheet of the present disclosure contains a fluororesin. The fluororesin has low dielectric properties and therefore can be suitably used for the purposes of the present disclosure.

The fluororesin as can be used in the present disclosure is not limited, but examples thereof include polytetrafluoroethylene [PTFE], a tetrafluoroethylene [TFE]/hexafluoropropylene [HFP] copolymer [FEP], a TFE/alkyl vinyl ether copolymer [PFA], a TFE/HFP/alkyl vinyl ether copolymer [EPA], a TFE/chlorotrifluoroethylene [CTFE] copolymer, a TFE/ethylene copolymer [ETFE], polyvinylidene difluoride [PVdF], and tetrafluoroethylene with a molecular weight of 300,000 or less [LMW-PTFE]. The fluororesin may be used singly or two or more thereof may be mixed and used.

From the viewpoint of low dielectric properties, the fluororesin is preferably a polytetrafluoroethylene (PTFE) resin, a tetrafluoroethylene [TFE]/hexafluoropropylene [HFP] copolymer [FEP], a TFE/alkyl vinyl ether copolymer [PFA], and particularly preferably a polytetrafluoroethylene (PTFE) resin. The PTFE resin is preferably fibrillatable. The PTFE resin being fibrillatable means a PTFE resin that can be extruded in paste form from unsintered polymer powder thereof.

(Polytetrafluoroethylene)

The PTFE may be modified polytetrafluoroethylene (hereinafter referred to as modified PTFE), homopolytetrafluoroethylene (hereinafter referred to as homo-PTFE), or a mixture of modified PTFE and homo-PTFE. Incidentally, from the viewpoint of maintaining favorable moldability of polytetrafluoroethylene, the content proportion of the modified PTFE in polymeric PTFE is preferably 10% by weight or more and 98% by weight or less and more preferably 50% by weight or more and 95% by weight or less. The homo-PTFE is not limited, and those disclosed in Japanese Patent Laid-Open No. 53-60979, Japanese Patent Laid-Open No. 57-135, Japanese Patent Laid-Open No. 61-16907, Japanese Patent Laid-Open No. 62-104816, Japanese Patent Laid-Open No. 62-190206, Japanese Patent Laid-Open No. 63-137906, Japanese Patent Laid-Open No. 2000-143727, Japanese Patent Laid-Open No. 2002-201217, International Publication No. WO2007/046345, International Publication No. WO2007/119829, International Publication No. WO2009/001894, International Publication No. WO2010/113950, International Publication No. WO2013/027850, and the like, can be suitably used. Among them, preferred are homo-PTFE having high stretchability and disclosed in Japanese Patent Laid-Open No. 57-135, Japanese Patent Laid-Open No. 63-137906, Japanese Patent Laid-Open No. 2000-143727, Japanese Patent Laid-Open No. 2002-201217, International Publication No. WO2007/046345, International Publication No. WO2007/119829, International Publication No. WO2010/113950, and the like.

The modified PTFE is composed of TFE and a monomer other than TFE (hereinafter referred to as a modifying monomer). Examples of the modified PTFE includes, but are not limited to, modified PTFE uniformly modified with the modifying monomer, modified PTFE modified at the beginning of a polymerization reaction, modified PTFE modified at the end of a polymerization reaction, and the like. The modified PTFE is preferably a TFE copolymer obtained by subjecting a small amount of monomer other than TFE to a polymerization together with TFE within a range that does not significantly impair the properties of a TFE homopolymer. The modified PTFE for use may be suitably, for example, those disclosed in Japanese Patent Laid-Open No. 60-42446, Japanese Patent Laid-Open No. 61-16907, Japanese Patent Laid-Open No. 62-104816, Japanese Patent Laid-Open No. 62-190206, Japanese Patent Laid-Open No. 64-1711, Japanese Patent Laid-Open No. 2-261810, Japanese Patent Laid-Open No. 11-240917, Japanese Patent Laid-Open No. 11-240918, International Publication No. WO 2003/033555, International Publication No. WO 2005/061567, International Publication No. WO 2007/005361, International Publication No. WO2011/055824, International Publication No. WO2013/027850, and the like. Among these, preferred are the modified PTFE having high stretchability and disclosed in Japanese Patent Laid-Open No. 61-16907, Japanese Patent Laid-Open No. 62-104816, Japanese Patent Laid-Open No. 64-1711, Japanese Patent Laid-Open No. 11-240917, International Publication No. WO2003/033555, International Publication No. WO2005/061567, International Publication No. WO2007/005361, International Publication No. WO2011/055824, and the like.

The modified PTFE includes a TFE unit based on TFE and a modifying monomer unit based on the modifying monomer. The modifying monomer unit is a portion of the molecular structure of the modified PTFE and is derived from the modifying monomer. The modified PTFE preferably contains a modifying monomer unit in an amount of 0.001 to 0.500% by weight and more preferably 0.01 to 0.30% by weight, of the total monomer unit. The total monomer unit is a portion derived from all monomers in the molecular structure of the modified PTFE.

The modifying monomer is not limited as long as it can be copolymerized with TFE, and examples thereof include a perfluoroolefin such as hexafluoropropylene (HFP); a chlorofluoroolefin such as chlorotrifluoroethylene (CTFE); hydrogen-containing fluoroolefins such as trifluoroethylene and vinylidene difluoride (VDF); perfluorovinyl ether; a perfluoroalkylethylene (PFAE), and ethylene. The modifying monomer to be used may be one type or a plural types thereof.

The perfluorovinyl ether is not limited, and examples thereof include an unsaturated perfluoro compound represented by the following general formula (1):

$$CF_2=CF-ORf \qquad (1)$$

wherein Rf represents a perfluoro organic group.

The perfluoro organic group as used herein is an organic group in which all hydrogen atoms bonded to carbon atoms are replaced with fluorine atoms. The perfluoro organic group may have an ether oxygen.

An example of the perfluorovinyl ether includes a perfluoro(alkyl vinyl ether) (PAVE) in which Rf in the general formula (1) described above is a perfluoroalkyl group having 1 to 10 carbon atoms. The number of carbon atoms in the perfluoroalkyl group is preferably 1 to 5. Examples of the perfluoroalkyl group in a PAVE include a perfluoromethyl group, a perfluoroethyl group, a perfluoropropyl group, a perfluorobutyl group, a perfluoropentyl group, and a perfluorohexyl group. A preferred PAVE is perfluoropropyl vinyl ether (PPVE) and perfluoromethyl vinyl ether (PMVE).

The perfluoroalkyl ethylene (PFAE) is not limited, and examples thereof include perfluorobutyl ethylene (PFBE) and perfluorohexyl ethylene (PFHE).

The modifying monomer in the modified PTFE is preferably at least one selected from the group consisting of HFP, CTFE, VDF, a PAVE, a PFAE and ethylene.

The fluororesin is preferably non-melt formable. The phrase non-melt formable means that a resin does not have sufficient flowability even when heated at its melting point or higher, and cannot be molded by melt forming techniques commonly used for resins.

In the present disclosure, it is preferable to use such a non-melt formable fluororesin and form it into a fluororesin sheet by a forming method for fibrillating the fluororesin. The molding method will be described later.

The PTFE preferably has an SSG of 2.0 to 2.3. The use of such PTFE facilitates a PTFE film having high strength (cohesion strength and puncture strength per unit thickness) to be obtained. PTFE with a large molecular weight has long molecular chains, making it less likely to form a structure of molecular chains regularly arranged. In this case, an amorphous portion elongates, resulting in an increase in the degree of entanglement between molecules. It is considered that the high degree of entanglement between molecules is less likely to allow a PTFE film to deform under an applied load and therefore to exhibit excellent mechanical strength. Also, using PTFE with a large molecular weight facilitates a PTFE film having a small average pore size to be obtained.

The lower limit of the SSG is more preferably 2.05 and still more preferably 2.1. The upper limit of the SSG is more preferably 2.25 and still more preferably 2.2.

The standard specific gravity [SSG] is measured by fabricating a sample in accordance with ASTM D-4895-89 and measuring the specific gravity of the obtained sample by a water displacement method.

In the present embodiment, the molecular weight (number-average molecular weight) of PTFE constituting PTFE powder is, for example, in the range of 200 to 12 million. The lower limit value of the molecular weight of PTFE may be 3 million or 4 million. The upper limit value of the molecular weight of PTFE may be 10 million.

A method for measuring the number-average molecular weight of PTFE includes a method for determining it from the standard specific gravity and a measurement method based on dynamic viscoelasticity upon melting. The method for determining a number-average molecular weight from the standard specific gravity can be carried out by using a sample formed in accordance with ASTM D-4895-98 and a water displacement method in accordance with ASTM D-792. The measurement method employing dynamic viscoelasticity is explained, for example, by S. Wu in Polymer Engineering & Science, 1988, Vol. 28, 538, and in the same literature, 1989, Vol. 29, 273.

Also, the PTFE preferably has the maximum endothermic peak temperature (crystalline melting point) of $340 \pm 7°C$.

The PTFE may be low-melting-point PTFE having the maximum peak temperature of 338°C or lower on an endothermic curve on a crystalline melting curve measured by a differential scanning calorimeter, or high-melting-point PTFE having the maximum peak temperature of 342°C or higher on an endothermic curve on a crystalline melting curve measured by a differential scanning calorimeter.

The low-melting-point PTFE is powder produced by a polymerization using an emulsion polymerization method, and has the maximum endothermic peak temperature (crystalline melting point), a dielectric constant ($\varepsilon$) of 2.08 to 2.2, and a dielectric loss tangent (tan $\delta$) of $1.9 \times 10^{-4}$ to $4.0 \times 10^{-4}$. Examples of a commercially available product thereof include POLYFLON Fine Powder F201, F203, F205, F301, and F302 manufactured by Daikin Industries, Ltd.; CD090 and CD076 manufactured by Asahi Glass Co., Ltd.; and TF6C, TF62, and TF40 manufactured by Dupont De Nemours Inc.

The high melting point PTFE powder is also powder produced by a polymerization using an emulsion polymerization method, and has the above-described maximum endothermic peak temperature (crystalline melting point), a dielectric constant ($\varepsilon$) of 2.0 to 2.1, and a dielectric loss tangent (tan $\delta$) of $1.6 \times 10^{-4}$ to $2.2 \times 10^{-4}$, which are overall low. Examples of a commercially available product thereof include POLYFLON Fine Powder F104 and F106 manufactured by Daikin Industries, Ltd.; CD1, CD141, and CD123 manufactured by Asahi Glass Co., Ltd.; and TF6 and TF65 manufactured by DuPont De Nemours Inc.

It is to be noted that an average particle size of powder in which both PTFE polymer particles have undergone secondary aggregation is usually preferably 250 to 2,000 $\mu$m. In particular, granulated powder obtained by granulation using a solvent is preferred from the viewpoint of improving flowability when filled in a mold upon preliminary forming.

The powdered PTFE that satisfies the aforementioned parameters can be obtained by conventional production methods. For example, it may be produced following the production methods described in International Publication No. WO2015/080291 and International Publication No. WO2012/086710.

(Melt-formable fluororesin)

As described above, it is most preferable that the dielectric of the present disclosure is a polytetrafluoroethylene resin. On the other hand, a melt-formable fluororesin can also be used to obtain a formed article having the aforementioned parameters. From such viewpoints, a melt-formable fluororesin will also be described in detail below.

The fluororesin is more preferably a melt-formable fluororesin, and examples thereof include a tetrafluoroethylene-perfluoroalkylvinyl ether copolymer (PFA), a copolymer having a chlorotrifluoroethylene (CTFE) unit (CTFE copolymer), a tetrafluoroethylene-hexafluoropropylene copolymer (FEP), a tetrafluoroethylene-ethylene copolymer (ETFE), polychlorotrifluoroethylene (PCTFE), a chlorotrifluoroethylene-ethylene copolymer (ECTFE), polyvinylidene difluoride (PVDF) and polyvinyl fluoride (PVF), a tetrafluoroethylene-hexafluoropropylene-vinylidene difluoride copolymer (THV), and a tetrafluoroethylene-vinylidene difluoride copolymer.

Among these melt-formable fluororesins, preferred are the tetrafluoroethylene-perfluoroalkylvinyl ether copolymer (PFA) and the tetrafluoroethylene-hexafluoropropylene copolymer (FEP).

The resin constituting the fluororesin film preferably has a glass transition temperature of 40°C or higher. The temperature of 40°C or higher makes it less likely for a roll film to deform in an environmental temperature, for example, when stored at room temperature, which is preferable in this respect, and the temperature is more preferably 60°C or higher and still more preferably 80°C or higher. The upper limit thereof is not limited, but from the viewpoint of adhesiveness, it is preferably 200°C or lower, more preferably 160°C, and still more preferably 120°C or lower.

The PFA preferably has a melting point of 180 to 340°C, more preferably 230 to 330°C, and still more preferably 280 to 320°C. The above-described melting point is a temperature corresponding to the maximum value in a heat-of-fusion curve when temperature is raised at a rate of 10°C/min., using a differential scanning calorimeter [DSC].

The PFA is not limited, but is preferably a copolymer having a mole ratio of a TFE unit to a PAVE unit (TFE unit/PAVE unit) of 70/30 or more and less than 99.5/0.5, more preferably 70/30 or more and 98.9/1.1 or less, and still more preferably 80/20 or more and 98.5/1.5 or less. Too few TFE units tend to reduce mechanical properties, and too many TFE units have a likelihood of a too high melting point, reducing moldability. The PFA may be a copolymer consisting of only TFE and a PAVE, or it is also preferably a copolymer having 0.1 to 10 mol% of a monomer unit derived from a monomer copolymerizable with TFE and a PAVE and 90 to 99.9 mol % of a TFE unit and a PAVE unit in total. Examples of the monomer copolymerizable with TFE and a PAVE include HFP, a vinyl monomer represented by $CZ^3Z^4=CZ^5(CF_2)_nZ^6$ (wherein $Z^3$, $Z^4$ and $Z^5$ are the same or different and represent a hydrogen atom or a fluorine atom, $Z^6$ represents a hydrogen atom, a fluorine atom or a chlorine atom, and n represents an integer of 2 to 10), and an alkyl perfluorovinyl ether derivative represented by $CF_2=CF-OCH_2-Rf^7$ (wherein $Rf^7$ represents a perfluoroalkyl group having 1 to 5 carbon atoms). Examples of other copolymerizable monomer include a cyclic hydrocarbon monomer having an acid anhydride group, and examples of an acid anhydride-based monomer include itaconic anhydride, citraconic anhydride, 5-norbornene-2,3-dicarboxylic anhydride, and maleic anhydride. The acid anhydride-based monomer may be used singly or in combination of two or more thereof.

The PFA has a melt flow rate (MFR) of preferably 0.1 to 100 g/10 min., more preferably 0.5 to 90 g/10 min., and still more preferably 1.0 to 85 g/10 min. The MFR as used herein is a value measured according to ASTM D3307 under conditions of a temperature of 372°C and a load of 5.0 kg.

The FEP is not limited, but is preferably a copolymer having a mole ratio of a TFE unit to a HFP unit (TFE unit/HFP unit) of 70/30 or more and less than 99/1. The mole ratio is more preferably 70/30 or more and 98.9/1.1 or less and still more preferably 80/20 or more and 97/3 or less. Too few TFE units tend to reduce mechanical properties, and too many TFE units have a likelihood of a too high melting point, reducing moldability. It is also preferable that the FEP is a copolymer including a monomer unit derived from a monomer copolymerizable with TFE and HFP in an amount of 0.1 to 10 mol %, and the total of a TFE unit and an HFP unit in an amount of 90 to 99.9 mol %. Examples of the monomer copolymerizable with TFE and HFP include an alkyl perfluorovinyl ether derivative. Examples of other copolymerizable monomer include a cyclic hydrocarbon monomer having an acid anhydride group, and examples of an acid anhydride-based monomer include itaconic anhydride, citraconic anhydride, 5-norbornene-2,3-dicarboxylic anhydride, and maleic anhydride. The acid anhydride-based monomer may be used singly or in combination of two or more thereof.

The FEP has a melting point of preferably 150 to 320°C, more preferably 200 to 300°C, and still more preferably 240 to 280°C. The melting point is a temperature corresponding to the maximum value on a heat-of-fusion curve when it is raised at a rate of 10°C/min., using a differential scanning calorimeter [DSC].

The FEP preferably has an MFR of 0.01 to 100 g/10 min., more preferably 0.1 to 80 g/10 min., still more preferably 1 to 60 g/10 min., and particularly preferably 1 to 50 g/10 min.

The fluororesin described above preferably has fewer functional groups, and in particular has fewer unstable terminal groups. Such a fluororesin is fabricated by adjusting conditions upon production (upon a polymerization reaction), by subjecting a fluororesin after polymerization to fluorine gas processing, heat treatment, supercritical gas extraction processing, or the like to reduce the number of unstable terminal groups, or by other method. In terms of excellent processing efficiency and the unstable terminal groups being partially or totally converted to $-CF_3$ groups to form stable terminal groups, the fluorine gas processing is preferable. Using the fluororesin with the reduced number of unstable terminal groups in such a manner reduces an electrostatic tangent and a loss of electrical signals, which is preferable in respect thereof.

The number of the unstable terminal groups is not limited, but is preferably 450 or less per $10^6$ main-chain carbon atoms of a fluororesin, more preferably 250 or less, still more preferably 100 or less, and most preferably 50 or less. In consideration of the effect of reducing a dielectric loss tangent, the number of the unstable terminal groups is preferably less than 10 and more preferably 5 or less.

Specific examples of the unstable terminal group include functional groups such as -COF, -COOH free (free COOH), -COOH bonded (associated -COOH), a hydroxyl group (such as $-CH_2OH$), $-CONH_2$, -COOR (such as $R=CH_3$), $-CF_2H$, and -OCOO-R (such as normal propyl carbonate).

The number of unstable terminal groups is specifically measured by the following method. First, the fluororesin is melted and compression-formed to fabricate a film having a thickness of 0.25 to 0.3 mm. This film is analyzed by Fourier transform infrared spectroscopy to obtain an infrared absorption spectrum of the fluororesin, and a difference spectrum is obtained from a base spectrum of the fluororesin which has been completely fluorinated and has no functional groups. From the absorption peak of a specific functional group that appears in this difference spectrum, the number of unstable terminal groups per $1 \times 10^6$ carbon atoms in the fluororesin is calculated according to the following formula (A):

$$N = I \times K/t \quad (A)$$

I: absorbance
K: coefficient of compensation
t: film thickness (mm)

For reference, absorption frequencies, molar extinction coefficients, and coefficients of compensation for the unstable terminal groups as used herein are shown in Table 1. The molar extinction coefficient was determined from FT-IR measurement data of a low molecular model compound.

[Table 1]

| Unstable terminal group | Absorption frequency (cm-1) | Molar extinction coefficient (1/cm/mol) | Coefficient of compensation | Model compound |
|---|---|---|---|---|
| -COF | 1883 | 600 | 388 | $C_7F_{15}COF$ |
| -COOH (free) | 1815 | 530 | 439 | $H(CF_2)_6COOH$ |
| -COOH (bonded) | 1779 | 530 | 439 | $H(CF_2)_6COOH$ |
| -COOCH3 | 1795 | 680 | 342 | $C_7F_{15}COOCH_3$ |
| -CONH2 | 3436 | 506 | 460 | $C_7F_{15}CONH_2$ |
| -CH2OH | 3648 | 104 | 2236 | $C_7F_{15}CH_2OH$ |
| -CF2H | 3020 | 8.8 | 26485 | $H(CF_2CF_2)_3CH_2OH$ |
| -OC(=O)O-R | 1817 | - | 1426 | - |

The fluorination treatment can be carried out by bringing a fluororesin that has not been subjected to fluorination treatment into contact with a fluorine-containing compound.

The fluorine-containing compound is not limited, but examples thereof include a fluorine radical source that generates a fluorine radical under fluorination treatment conditions. Examples of the fluorine radical source include $F_2$ gas, $CoF_3$, $AgF_2$, $UF_6$, $OF_2$, $N_2F_2$, $CF_3OF$, and halogen fluorides (for example, $IF_5$, $ClF_3$).

The fluorine radical source such as the $F_2$ gas may be of 100% concentration, but from the standpoint of safety, it is preferable to mix it with an inert gas and dilute the mixture to 5 to 50% by mass to use, and it is more preferable to dilute it to 15 to 30% by mass to use. Examples of the inert gas include nitrogen gas, helium gas, and argon gas, with nitrogen gas being preferred from an economic point of view.

The conditions for the fluorination treatment are not limited, and a fluororesin in molten state may be brought into contact with a fluorine-containing compound, but a fluororesin can be usually treated at the melting point of the fluororesin or lower, preferably 20 to 220°C and more preferably 100 to 200°C. The fluorination treatment is generally carried out for 1 to 30 hours, preferably 5 to 25 hours. The fluorination treatment is preferably treatment where a fluororesin that has not been subjected to fluorination treatment is brought into contact with fluorine gas (F2 gas).

The content of each monomer unit constituting the fluororesin as used herein can be calculated by appropriately combining NMR, FT-IR, elemental analysis, and X-ray fluorescence analysis depending on the type of monomer.

(Spherical filler)

The dielectric of the present disclosure preferably contains a filler. Compounding the filler enables reducing a coefficient of linear expansion, which is particularly preferable in this respect.

The filler that can be used in the present disclosure is not limited, and examples thereof include one or more organic fillers selected from an aramid fiber, polyphenyl ester, polyphenylene sulfide, polyimide, polyether ether ketone, polyphenylene, polyamide, or a wholly aromatic polyester resin, and one or more inorganic fillers selected from ceramics, talc, mica, alumina, zinc oxide, tin oxide, titanium oxide, silicon oxide, calcium carbonate, calcium oxide, magnesium oxide, potassium titanate, a glass fiber, a glass chip, a glass bead, silicon carbide, calcium fluoride, boron nitride, barium sulfate, molybdenum disulfide, forsterite, or a potassium carbonate whisker. Two or more thereof may be combined for use.

Among these, at least one selected from the group consisting of silica, titanium oxide, alumina, and forsterite is particularly preferable from the viewpoint of its low loss. Furthermore, silica is most preferable.

The spherical filler consisting only of spherical silica is particularly preferable. As described above, the filler is compounded for the purpose of reducing a coefficient of linear expansion, but a filler with a high anisotropy makes it difficult for a dielectric to satisfies the aforementioned each property thereof. The spherical silica is preferable in terms of having a small anisotropy and the frequency dependence of the dielectric constant.

The spherical silica particle refers to a particle, the shape of which is close to a perfect sphere. Specifically, the sphericity is preferably 0.80 or more, more preferably 0.85 or more, still more preferably 0.90 or more, and most preferably 0.95 or more. The sphericity is calculated by taking a photograph of the particle with an SEM and calculating a value from an area and an perimeter of the particle observed, by formula : (sphericity) = $\{4\pi \times (\text{area})/(\text{perimeter})2\}$. The closer the sphericity is to 1, the closer the particle is to a perfect sphere. Specifically, an average value measured for 100 particles is adopted using an image processing device (FPIA-3000 manufactured by Spectris PLC).

The spherical silica particle used in the present disclosure preferably has D90/D10 of 2 or more (preferably 2.3 or more, 2.5 or more) and D50 of 10 $\mu$m or less when integrating its volume from the smallest particle size. Furthermore, D90/D50 is preferably 1.5 or more (more preferably 1.6 or more). D50/D10 is preferably 1.5 or more (more preferably 1.6 or more). A spherical silica particle with a small particle size can enter a gap between spherical silica particles with a large particle size, making it possible to achieve excellent filling property and high flowability. In particular, a particle size distribution of the particle with a high frequency of small particle sizes, is preferable compared to a Gaussian curve. The particle size can be measured by a laser diffraction-scattering type particle size distribution measurement apparatus. Also, coarse particles having a particle size of a predetermined size or more are preferably removed using a filter or the like.

The spherical silica particle preferably has a water absorption of 1.0% or less and more preferably 0.5% or less. The water absorption is based on the mass of the silica particles when dry. The water absorption is measured by allowing a sample to be left standing in a dry state at 40°C and 80% RH for 1 hour, measuring water generated by heating at 200°C using a Karl Fischer moisture meter, and calculating the water absorption.

Also, the dielectric may be heated at 600°C for 30 minutes in an air atmosphere to burn off the fluororesin and extract spherical silica particles then to measure each of the above parameters of the spherical silica particles, using the aforementioned method as well.

The silica particle used in the present disclosure may be surface-treated. The preliminary surface treatment enables silica particles to be inhibited from its aggregation and allows the silica particles to be favorably dispersed in the resin composition. It is also preferable in terms of being capable of reducing the dielectric loss tangent.

The surface treatment is not limited, and any known surface treatment can be employed. Specific examples thereof include treatment with silane coupling agents such as epoxy silane having a reactive functional group, amino silane, isocyanate silane, vinyl silane, acrylic silane, hydrophobic alkyl silane, phenyl silane, and fluorinated alkyl silane, plasma processing, and fluorination treatment.

Examples of the silane coupling agent include epoxy silanes such as γ-glycidoxypropyltriethoxysilane and β-(3,4-epoxycyclohexyl)ethyltrimethoxysilane, amino silanes such as aminopropyltriethoxysilane and N-phenylaminopropyltrimethoxysilane, isocyanate silane such as 3-isocyanatepropyltrimethoxysilane, vinyl silanes such as vinyltrimethoxysilane, and acrylic silanes such as acryloxytrimethoxysilane.

The spherical silica particle to be used may be a commercially available silica particle that satisfy the properties described above. Examples of the commercially available silica particle include DENKA FUSED SILICA FB Grade (manufactured by Denka Company Limited), Denka FUSED SILICA SFP Grade (manufactured by Denka Company Limited), EXELICA (manufactured by Tokuyama Corporation), a high-purity synthetic spherical silica particle ADMAFINE (manufactured by Admatechs Co., Ltd.), ADMANANO (manufactured by Admatechs Co., Ltd.), and ADMAFUSE (manufactured by Admatechs Co., Ltd.).

More specifically, it is particularly preferably those surface-treated with aminopropylsilane, aminosilane, vinylsilane, hydrophobic alkylsilane, phenylsilane, 3-mercaptopropylsilane, 3-acryloxypropylsilane, 3-methacryloxypropylsilane, p-styrylsilane, silylpropylsuccinic anhydride, 3-isocyanatopropylsilane, 2-(3,4-epoxycyclohexyl)ethylsilane, and the like.

The surface treatment using these silane coupling agents allows a polar functional group present on a filler surface to react and reduces the amount of a polar functional group, resulting in excellent electrical characteristics.

(Composition)

The dielectric of the present disclosure contains the aforementioned filler and fluororesin. The dielectric may contain a component other than the filler and fluororesin, or may consist only of the filler and fluororesin. The content of the component other than the filler and fluororesin is preferably 10% by weight or less.

The dielectric of the present disclosure preferably has a filler content of 70% by weight or less relative to the total amount of the composition. Containing the filler in such a range enables a coefficient of linear expansion to be reduced, which is preferable in terms of facilitation of moldability.

The lower limit of the amount of filler compounded is not limited, but is preferably 40% by weight from the viewpoint of reducing the coefficient of linear expansion.

The upper limit thereof is more preferably 68% by weight and still more preferably 65% by weight. The lower limit is more preferably 40% by weight and still more preferably 45% by weight.

The dielectric of the present disclosure preferably has a coefficient of linear expansion of 10 to 100 (ppm/°C). Within the above range thereof, the dielectric is preferable in terms of having low shrinkage and excellent dimensional stability. The upper limit thereof is more preferably 90 and still more preferably 80. The lower limit thereof is more preferably 12 and still more preferably 15. The coefficient of linear expansion as used herein was determined by making a TMA measurement in tensile mode using a TMA-7100 (manufactured by Hitachi High-Tech Science Corporation), using a sheet cut to a length of 20 mm, width of 5 mm, and thickness of 0.1 to 0.5 mm as a sample piece, setting a chuck distance to 10 mm, and measuring the amount of sample displaced while applying a load of 49 mN, at -10 to 160°C (rate of temperature rise of 2°C/min).

(Production method of fluororesin sheet)

In the case of the fluororesin of polytetrafluoroethylene, the fluororesin sheet of the present disclosure can be obtained by mixing a fluororesin particle and a filler to form the mixture into a sheet. The method for producing the sheet is not limited, but paste extrusion forming, powder rolling forming, and the like can be employed. In the case of a melt-formable fluororesin, the method for producing a sheet is not limited, and injection molding, blow forming, inflation forming, vacuum/pressure forming, extrusion forming, and the like, can be employed, and an apparatus to be used for melt kneading is not limited, and a twin screw extruder, a single screw extruder, a multi-screw extruder, a tandem extruder, or the like can be used.

As described above, it is preferable to use a fluororesin that is non-melt-formable as a fluororesin to be used in the fluororesin sheet of the present disclosure. When using such a fluororesin and forming it into a sheet, it is preferable to form it into a sheet by fibrillating powdered PTFE as a raw material.

It is preferable to use the powdered PTFE having a primary particle size of 0.05 to 10 $\mu$m. Using such powdered PTFE has an advantage of excellent dispersibility. It is to be noted that the primary particle size as used herein is a value measured in accordance with ASTM D 4895.

The powdered PTFE contains a polytetrafluoroethylene resin having a secondary particle size of 500 $\mu$m or more in an amount of preferably 50% by mass or more and more preferably 80% by mass or more. The PTFE having a secondary particle size of 500 $\mu$m or more within the above range, has an advantage of being capable of fabricating a mixture sheet with high strength.

Using the PTFE having a secondary particle size of 500 $\mu$m or more enables a mixture sheet with lower resistance and greater toughness to be obtained.

The lower limit of the secondary particle size is more preferably 300 $\mu$m and still more preferably 350 $\mu$m. The upper limit of the secondary particle size is more preferably 700 $\mu$m or less and still more preferably 600 $\mu$m or less. The secondary particle size can be determined, for example, by a sieving method or the like.

The powdered PTFE described above can provide a fluororesin sheet with higher strength and excellent homogeneity, so that an average primary particle size thereof is preferably 50 nm or more, more preferably 100 nm or more, still more preferably 150 nm or more, and particularly preferably 200 nm or more. The larger the average primary particle size of PTFE is, the more inhibited an increase in paste extrusion pressure upon paste extrusion forming using the powder will be, resulting in excellent moldability as well. The upper limit of the average primary particle size of PTFE is not limited, but it may be 500 nm. From the viewpoint of productivity in a polymerization process, it is preferably 350 nm.

The average primary particle size can be determined by preparing a calibration curve of a transmission of projected light of 550 nm relative to a unit length of an aqueous dispersion obtained by using an aqueous dispersion of PTFE obtained by polymerization and adjusting its polymer concentration to 0.22% by mass, and an average primary particle size determined by measuring an unidirectional diameter of the particle observed in a photograph of the particle by a transmission electron microscope, and then measuring the transmission of the aqueous dispersion to be measured, based on the calibration curve.

The PTFE to be used in the present disclosure may have a core-shell structure. An example of the PTFE having a core-shell structure includes modified polytetrafluoroethylene which contains a core of high molecular weight polytetrafluoroethylene in the particle and a shell of lower molecular weight polytetrafluoroethylene or modified polytetrafluoroethylene. An example of such modified polytetrafluoroethylene includes the polytetrafluoroethylene described in Japanese Translation of PCT International Application Publication No. 2005-527652.

Specific methods of paste extrusion forming and powder rolling forming are not limited, and a general method will be described below.

(Paste extrusion forming)

A method for producing the sheet may include the steps of (1a) mixing PTFE powder obtained by using a hydrocarbon surfactant with an auxiliary agent for extrusion, (1b) subjecting the mixture obtained to paste extrusion forming, (1c) rolling the extrudate obtained by extrusion forming, (1d) drying the rolled sheet, and (1e) sintering the dried sheet to obtain a formed article. The paste extrusion forming may also be performed by adding a conventionally and publicly known additive such as a pigment or a filler to the PTFE powder.

The auxiliary agent for extrusion is not limited, and any publicly known agent may be used. Examples thereof include hydrocarbon oil and the like.

(Powder rolling forming)

The sheet can also be formed by powder rolling forming. The powder rolling forming is a method for applying shear force to resin powder followed by fibrillation thereof, and thus forming it into a sheet. This method may include the step of sintering the sheet thereafter to obtain a formed article.

More specifically, the sheet can be obtained by a production method thereof, having step (1) of applying shear force while mixing a raw material composition containing a fluororesin and a filler,

step (2) of forming the mixture obtained by step (1) into a bulk form, and
step (3) of rolling the mixture in bulk form obtained by step (2) into a sheet.

It is to be noted that in the case of obtaining a sheet by such powder rolling forming, it is preferable to mix only a fluororesin particle and an inorganic filler to form the sheet.

(Laminate)

The dielectric of the present disclosure can be used as a sheet for a printed wiring board by stacking it with other substrate.

Copper foil can be adhered to one or both sides of the aforementioned dielectric to form a copper-clad laminate. As described above, the film containing the fluororesin of the present disclosure is particularly suitable for use in printed wiring board applications, and therefore can be suitably used as such a copper-clad laminate.

The copper foil preferably has an Rz of 1.6 $\mu$m or less. That is, the fluororesin composition of the present disclosure also has excellent adhesiveness to copper foil with a high smoothness of Rz of 1.6 $\mu$m or less.

Furthermore, the copper foil is only required to have an Rz value of 1.6 $\mu$m or less on at least a surface in adhesion with the aforementioned fluororesin film, and the other surface is not limited in terms of the Rz value.

A thickness of the copper foil is not limited, but is preferably in the range of 1 to 100 $\mu$m, more preferably in the range of 5 to 50 $\mu$m, and still more preferably in the range of 9 to 35 $\mu$m.

The copper foil is not limited, and specific examples thereof include rolled copper foil and electrolytic copper foil.

The copper foil having an Rz of 1.6 $\mu$m or less is not limited, and commercially available products can be used. An example of commercially available copper foil having an Rz of 1.6 $\mu$m or less includes electrolytic copper foil CF-T9DA-SV-18 (thickness 18 $\mu$m/Rz 0.85 $\mu$m) (manufactured by Fukuda Metal Foil Powder Co., Ltd.).

The copper foil may also be surface-treated in order to increase its adhesion strength with the fluororesin film of the present disclosure.

The surface treatment is not limited, but may be silane coupling treatment, plasma processing, corona processing, UV processing, electron beam processing, and the like, and a reactive functional group of the silane coupling agent is not limited, and from the viewpoint of adhesiveness to a resin substrate, the reactive functional group preferably has at least one selected from an amino group, a (meth)acrylic group, a mercapto group, and an epoxy group at the end. Also, a hydrolyzable group is not limited, but examples thereof include alkoxy groups such as a methoxy group and an ethoxy group. The copper foil to be used in the present disclosure may also have a rust-proof layer (such as an oxide film such as chromate), a heat-resistant layer, and the like.

Surface-treated copper foil having a surface-treating layer treated with the silane compound on a surface of the copper foil can be produced by preparing a solution containing the silane compound and then subjecting the copper foil to surface treatment with the solution.

The copper foil may have a roughening treatment layer on a surface from the viewpoint of enhancing adhesiveness to a resin substrate.

Incidentally, when there is a risk that the roughening treatment will lower the performance required in the present disclosure, the amount of roughened particles electrodeposited on a surface of the copper foil may be reduced, if necessary, or an embodiment of not carrying out the roughening treatment may be adopted.

From the viewpoint of improving various properties, one or more layers selected from the group consisting of a heat treatment layer, an rust-proof processing layer, and a chromate processing layer may be arranged between copper foil and the surface-treating layer. These layers may be a single layer or a plurality of layers.

The copper-clad laminated board may further have a layer other than the copper foil and the dielectric. The layer other than the copper foil and the fluororesin film is preferably at least one selected from the group consisting of polyimide, modified polyimide, a liquid crystal polymer, polyphenylene sulfide, a cycloolefin polymer, polystyrene, an epoxy resin, bismaleimide, polyphenylene oxide, polyphenylene ether, modified polyphenylene ether, and polybutadiene.

The layer other than the copper foil and dielectric is not limited as long as it is composed of the aforementioned resin. Also, the layer other than the copper foil and the fluororesin film preferably has a thickness within the range of 12.5 to 260 μm.

The copper-clad laminated board may have a copper layer formed on one or both sides of a roll film. Examples of a method for forming the copper layer include a method for stacking (adhering) copper foil on a surface of the roll film, a vapor deposition method, a plating method, and the like. An example of the method for stacking copper foil includes a method using heat press. An example of a heat press temperature upon heat press includes a temperature between the melting point of the dielectric film -150°C and the melting point of the dielectric film +40°C. A heat press time is, for example, 1 to 30 minutes. A heat press pressure may be 0.1 to 10 MPa. The copper-clad laminated board can be produced by the above methods.

The use of the copper-clad laminated board is not limited, and it is used as a circuit board. A printed circuit board is a platy component for electrically connecting an electronic component such as a semiconductor and a capacitor chip, and simultaneously arranging and fixing them in a limited space. A configuration of a printed circuit board formed from the present copper-clad laminate is not limited. The printed circuit board may be any of a rigid board, a flexible board, or a rigid-flexible board. The printed circuit board may be any of a single-sided board, a double-sided board, or a multi-layered board (such as a built-up board). In particular, it is suitably used for a flexible board or a rigid board. It is particularly suitable for use as a printed circuit board for high frequencies of 110 GHz or higher.

The circuit board is not limited, and can be produced by a general method using the aforementioned copper-clad laminate board.

A laminate for circuit boards is also a laminate characterized in that it has a copper foil layer, the aforementioned fluororesin film, and a substrate layer. The substrate layer is not limited, but preferably has a fabric layer composed of glass fibers and a resin film layer.

The fabric layer composed of glass fibers is a layer composed of glass cloth, a glass nonwoven fabric, or the like.

Commercially available glass cloth can be used, and it is preferably cloth treated with a silane coupling agent in order to enhance its affinity with a fluororesin. Examples of a glass cloth material include E glass, C glass, A glass, S glass, D glass, NE glass, and glass with a low dielectric constant, and the E glass, S glass, and NE glass are preferable in terms of their facilitation of availability. Weave of fibers may be plain weave or twill weave. A thickness of the glass cloth is usually 5 to 90 μm, preferably 10 to 75 μm, but it is preferable to use glass cloth that is thinner than a fluororesin film to be used.

The laminate may be a laminate in which a glass nonwoven fabric is used as a fabric layer composed of glass fibers. The glass nonwoven fabric is fabric in which glass staple fibers are fixed with a small amount of a binder compound (resin or inorganic substance), or fabric in which glass staple fibers are entangled without using a binder compound to maintain its shape, and commercially available products can be used. The diameter of the glass staple fiber is preferably 0.5 to 30 μm, and the fiber length is preferably 5 to 30 mm. Specific examples of the binder compound include resins such as an epoxy resin, an acrylic resin, cellulose, polyvinyl alcohol, and a fluororesin, and an inorganic substance such as a silica compound. The amount of binder compound used is usually 3 to 15% by mass of the glass staple fiber. Examples of a material for the glass staple fiber include E glass, C glass, A glass, S glass, D glass, NE glass, and glass with a low dielectric constant. A thickness of the glass nonwoven fabric is usually 50 to 1,000 μm and preferably 100 to 900 μm. Incidentally, the thickness of the glass nonwoven fabric as used herein means a value measured using a digital gauge DG-925 (load 110 grams, surface diameter 10 mm) manufactured by ONO SOKKI CO., LTD. in accordance with JIS P8118:1998. In order to enhance the affinity with a fluororesin, the glass nonwoven fabric may be subjected to treatment with a silane coupling agent.

Most glass nonwoven fabrics have a very high porosity of 80% or more, so that it is preferable to use fabric thicker than a sheet composed of a fluororesin, compress it by pressure, and then use it.

The fabric layer composed of the glass fibers may be a layer stacked with glass cloth and a glass nonwoven fabric. This allows the properties of each to be combined to obtain optimal properties.

The fabric layer composed of the glass fiber may be in the form of a prepreg impregnated with resin.

The laminate may be a laminate in which a fabric layer composed of glass fibers and a fluororesin film have been adhered at the interface thereof, wherein the fabric layer composed of glass fibers may be partially or totally impregnated with the fluororesin film.

Furthermore, the laminate may be a laminate in which fabric composed of glass fibers is impregnated with a fluororesin composition to produce a prepreg. The prepreg thus obtained may be stacked with the fluororesin film of the present disclosure. In this case, a fluororesin composition to be used upon production of the prepreg is not limited, and the fluororesin film of the present disclosure can be used.

A resin film to be used as the substrate layer is preferably a heat-resistant resin film or a thermosetting resin film. Examples of the heat-resistant resin film include polyimide, modified polyimide, a liquid crystal polymer, and polyphenylene sulfide. Examples of the thermosetting resin include an epoxy resin, bismaleimide, polyphenylene oxide, polyphenylene ether, modified polyphenylene ether, and polybutadiene.

The heat-resistant resin film and the thermosetting resin film may contain a reinforcing fiber. The reinforcing fiber is not limited, but for example, glass cloth, particularly those of low dielectric type, are preferable.

The properties of the heat-resistant resin film and the thermosetting resin film, such as the dielectric properties, coefficient of linear expansion, and water absorption rate, are not limited, but for example, the dielectric constant at 20 GHz is preferably 3.8 or less, more preferably 3.4 or less, and still more preferably 3.0 or less. The dielectric loss tangent at 20 GHz is preferably 0.0030 or less, more preferably 0.0025 or less, and still more preferably 0.0020 or less. The coefficient of linear expansion is preferably 100 ppm/°C or less, more preferably 70 ppm/°C or less, and still more preferably 40 ppm/°C or less. The water absorption rate is preferably 1.0% or less, more preferably 0.5% or less, and still more preferably 0.1% or less.

[Examples]

The present disclosure will be specifically described below based on Examples. In the following examples, "part" and "%" represent "parts by mass" and "% by mass", respectively, unless otherwise specified.

Sheet Fabrication Method 1 (paste extrusion forming)

The predetermined amounts of fluororesin powder (PTFE) and spherical silica were weighed out in the proportions shown in Table 3 and mixed in a mixer in the presence of dry ice. The temperature during mixing was -10°C or lower.

Oil (IP Solvent 2028) was added to the obtained mixed powder in a concentration of 18 to 23 wt%, mixed, and aged for about 5 hours.

The aged composition was preliminarily formed under the condition of a pressure of 3 MPa, and the formed article preliminarily formed was extruded under conditions of 40°C and 50 mm/min. to obtain an extrusion sample. The extrusion sample was rolled with two rolls (a roll gap was set to 500 - 80 $\mu$m) to obtain a sample with a thickness of 125 $\mu$m. The sample was dried at 200°C for 2 hours and sintered at 360°C for 15 minutes to obtain a sheet.

Sheet fabrication method 2 (powder rolling forming)

The predetermined amounts of fluororesin powder (PTFE) and silica was weighed out in the proportions shown in Table 3, and the mixture was stirred at room temperature with a Wonder Crusher at memory 6 for 30 seconds × 2 times. The obtained powder was rolled with two rolls (a roll gap was set to 100 $\mu$m) to obtain a sample with a thickness of 130 $\mu$m. The sample was then sintered at 360°C for 15 minutes to obtain a sheet.

It is to be noted that the spherical silica used in each Example was SC6500-SQ (average particle size: 2.1 $\mu$m) manufactured by Admatechs Co., Ltd. as a raw material, and the spherical silica in some Examples was subjected to the surface treatment as shown in Table 2. The spherical silica in Example 9 was FE920D-SQ (average particle size: 5.8 $\mu$m), manufactured by Admatechs Co., Ltd., and the spherical silica in Example 10 was 20GA-C2 (average particle size: 2.0 $\mu$m) manufactured by Admatechs Co., Ltd.

It is to be noted that the fluororesin powder (PTFE) used has the following properties:

Average particle size: 500 $\mu$m
Apparent density: 460 g/L
Standard specific gravity: 2.17
Measurement method: In accordance with ASTM D 4895

[Table 2]

| Processing contents | Processing amount | |
|---|---|---|
| Example 1 | Unprocessed | |
| Example 2 | Aminopropyl processing | 1% by weight |
| Example 3 | Unprocessed | |
| Example 4 | Aminopropyl processing | 1% by weight |
| Example 5 | Unprocessed | |
| Example 6 | Aminopropyl processing | 1% by weight |
| Example 7 | Unprocessed | |
| Example 8 | Aminopropyl processing | 1% by weight |
| Example 9 | Unprocessed | |
| Example 10 | Unprocessed | |

[Table 3]

| | Amount of silica compounded | Amount of fluororesin compounded | Sheet forming method |
|---|---|---|---|
| Example 1 | 60% by weight | 40% by weight | Sheet forming method 1 |
| Example 2 | 60% by weight | 40% by weight | Sheet forming method 1 |
| Example 3 | 60% by weight | 40% by weight | Sheet forming method 2 |
| Example 4 | 60% by weight | 40% by weight | Sheet forming method 2 |
| Example 5 | 50% by weight | 50% by weight | Sheet forming method 1 |
| Example 6 | 50% by weight | 50% by weight | Sheet forming method 1 |
| Example 7 | 50% by weight | 50% by weight | Sheet forming method 2 |
| Example 8 | 50% by weight | 50% by weight | Sheet forming method 2 |
| Example 9 | 50% by weight | 50% by weight | Sheet forming method 2 |
| Example 10 | 50% by weight | 50% by weight | Sheet forming method 2 |

(Etching)

The copper foil with a resin layer (RO3003G2, NF-30) was etched with an aqueous solution of ferric chloride, cleaned with running fresh water for 2 to 5 minutes, further cleaned with distilled water, and then dried for about 60 minutes in a constant-temperature vessel at a temperature of 80 $\pm$ 3°C to recover the single resin layer.

(Comparative Example 1)

A commercially available copper-clad laminated board, RO3003G2 (manufactured by Rogers Corporation), was etched to obtain a resin layer.

(Comparative Example 2)

A commercially available copper-clad laminated board, NF-30 (manufactured by Taconic), was etched to obtain a resin layer.

(Evaluation method)

(Measurement method of dielectric constant and dielectric loss tangent)

Under the conditions of room temperature of 25°C and humidity of 50%, a network analyzer (N5290A, manufactured by Keysight Technologies Inc.) and a Fabry-Perot resonator J-band (220 to 330 GHz) and D-band (110 to 170 GHz) (FP-J, FP-D, manufactured by EM Labs, Inc.), were used to measure the dielectric constant (Dk) and dielectric loss tangent (Df) at each frequency.

The results are shown in Table 4.

[Table 4]

| | Slope of dielectric constant (Dk) from 220 GHz to 330 GHz | 90° anisotropy of dielectric constant (Dk) in planar direction of dielectric at 170 GHz | Dielectri c loss tangent (Df) at 220 GHz | Dielectri c loss tangent (Df) at 330 GHz | Coefficien t of linear expansio n (ppm/°C) |
|---|---|---|---|---|---|
| Example 1 | 0.000075 | 0.015 | 0.00149 | 0.00161 | 44 |
| Example 2 | 0.000125 | 0.014 | 0.00150 | 0.00162 | 35 |
| Example 3 | 0.000077 | 0.015 | 0.00148 | 0.00160 | 46 |
| Example 4 | 0.000121 | 0.014 | 0.00147 | 0.00159 | 36 |
| Example 5 | 0.000061 | 0.011 | 0.00128 | 0.00152 | 66 |
| Example 6 | 0.000109 | 0.010 | 0.00127 | 0.00154 | 57 |
| Example 7 | 0.000059 | 0.012 | 0.00129 | 0.00153 | 64 |
| Example 8 | 0.000107 | 0.009 | 0.00128 | 0.00151 | 55 |
| Example 9 | 0.000105 | 0.010 | 0.00127 | 0.00150 | 56 |
| Example 10 | 0.000089 | 0.008 | 0.00116 | 0.00142 | 69 |
| Comparative Example 1 | 0.000600 | 0.0452 | 0.00156 | 0.00168 | 30 |
| Comparative Example 2 | 0.000950 | 0.0248 | 0.00205 | 0.00209 | 28 |

Table 4 shows that the dielectrics of Examples 1 to 10 have a small difference in the dielectric constant at frequencies from 220 to 330 GHz, and such dielectrics when formed into a copper-clad laminate, are not required to change a wiring width of copper wiring for each frequency. Also, the dielectric with a small anisotropy of the dielectric constant at 170 GHz can be obtained, making it possible to freely design copper wiring having a pattern other than a straight line.

Furthermore, it is preferable that the dielectric loss tangent (Df) for each frequency of 220 GHz and 330 GHz is low. The use of dielectric with the low dielectric loss tangent (Df) reduces the transmission loss at 220 to 330 GHz, which is preferable.

Industrial Applicability

Particularly, the dielectric of the present disclosure can be suitably used for high-frequency printed circuit boards at frequencies of 110 GHz or higher.

**Claims**

1. A dielectric having a slope of a dielectric constant (Dk) with respect to frequencies from 220 GHz to 330 GHz of 0.00001 or more and 0.0005 or less, as measured with a Fabry-Perot resonator J-band.

2. A dielectric having a 90° anisotropy of a dielectric constant (Dk) in a planar direction of the dielectric at 170 GHz of 0.02 or less, as measured with a Fabry-Perot resonator J-band.

3. A dielectric having a dielectric loss tangent (Df) at 220 GHz of 0.00153 or less, as measured with a Fabry-Perot resonator J-band.

4. A dielectric having a dielectric loss tangent (Df) at 330 GHz of 0.00165 or less, as measured with a Fabry-Perot resonator J-band.

5. The dielectric according to any one of claims 1 to 4, comprising a resin and a spherical filler.

6. The dielectric according to claim 5, wherein the filler is at least one selected from the group consisting of silica, titanium oxide, alumina, and forsterite.

7. The dielectric according to claim 5 or 6, wherein the filler is substantially spherical silica.

8. The dielectric according to any one of claims 5 to 7, wherein the filler has an average particle size of 0.1 to 10 $\mu$m.

9. The dielectric according to any one of claims 5 to 8, wherein the resin is a fluororesin.

10. The dielectric according to claim 9, wherein the fluororesin is partially or totally at least one polymer selected from the group consisting of a polytetrafluoroethylene resin, a tetrafluoroethylene-perfluoroalkylvinylether copolymer, and a tetrafluoroethylene-hexafluoropropylene copolymer.

11. The dielectric according to claim 9 or 10, obtained by using a fluororesin particle having a primary particle size of 0.05 to 10 $\mu$m as a raw material.

12. The dielectric according to claim 11, wherein the fluororesin particle has a particle size at a cumulative volume of 50% of 0.05 to 40 $\mu$m.

13. The dielectric according to any one of claims 1 to 12, used for a terahertz-band printed circuit board, a terahertz-band dielectric material, or a terahertz-band laminate circuit board.

14. The dielectric according to any one of claims 1 to 13, having a sheet shape.

15. A method for producing the dielectric according to claim 14, comprising mixing a fluororesin particle and a filler to form a film.

16. A method for producing the dielectric according to claim 14, comprising mixing a fluororesin particle and a filler to form a film without addition of other components.

17. A copper-clad laminate comprising copper foil and the dielectric according to claim 14 as essential layers, wherein the copper-clad laminate is used for a terahertz-band printed circuit board, a terahertz-band dielectric material, or a terahertz-band laminate circuit board.

18. A circuit board, having the copper-clad laminate according to claim 17.

<div align="center">

## INTERNATIONAL SEARCH REPORT

</div>

| International application No. |
| --- |
| **PCT/JP2023/036266** |

**A.    CLASSIFICATION OF SUBJECT MATTER**

*H01B 3/00*(2006.01)i; *B32B 15/082*(2006.01)i; *B32B 15/20*(2006.01)i; *B32B 27/30*(2006.01)i; *C08K 3/013*(2018.01)i;
*C08K 7/18*(2006.01)i; *C08L 27/12*(2006.01)i; *H05K 1/03*(2006.01)i
FI:    H01B3/00 A; B32B15/082 B; B32B15/20; B32B27/30 D; C08K3/013; C08K7/18; C08L27/12; H05K1/03 610H

According to International Patent Classification (IPC) or to both national classification and IPC

**B.    FIELDS SEARCHED**

Minimum documentation searched (classification system followed by classification symbols)

H01B3/00; B32B15/082; B32B15/20; B32B27/30; C08K3/013; C08K7/18; C08L27/12; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2020/213669 A1 (NITTO DENKO CORPORATION) 22 October 2020 (2020-10-22) | 1-18 |
| A | WO 2021/235276 A1 (SUMITOMO ELECTRIC INDUSTRIES, LTD.) 25 November 2021 (2021-11-25) | 1-18 |
| A | JP 2022-131074 A (SHINETSU CHEMICAL CO) 07 September 2022 (2022-09-07) | 1-18 |
| A | WO 2020/027172 A1 (NITTO DENKO CORPORATION) 06 February 2020 (2020-02-06) | 1-18 |
| A | WO 2019/087939 A1 (AGC INC.) 09 May 2019 (2019-05-09) | 1-18 |
| A | CN 112848358 A (NANJING RUIMA MILLIMETER-WAVE TERAHERTZ TECHNOLOGY RESEARCH INSTITUTE CO., LTD.) 28 May 2021 (2021-05-28) | 1-18 |

☐ Further documents are listed in the continuation of Box C.     ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **04 December 2023** | **19 December 2023** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2023/036266**

| Patent document cited in search report | | | Publication date (day/month/year) | Patent family member(s) | | | Publication date (day/month/year) |
|---|---|---|---|---|---|---|---|
| WO | 2020/213669 | A1 | 22 October 2020 | US | 2022/0220265 | A1 | |
| | | | | CN | 113710733 | A | |
| | | | | KR | 10-2022-0005454 | A | |
| WO | 2021/235276 | A1 | 25 November 2021 | US | 2022/0272838 | A1 | |
| | | | | EP | 4155052 | A1 | |
| | | | | CN | 114258343 | A | |
| JP | 2022-131074 | A | 07 September 2022 | US | 2022/0275158 | A1 | |
| | | | | CN | 114980495 | A | |
| | | | | KR | 10-2022-0122507 | A | |
| WO | 2020/027172 | A1 | 06 February 2020 | US | 2021/0221106 | A1 | |
| | | | | CN | 112512788 | A | |
| | | | | KR | 10-2021-0040369 | A | |
| WO | 2019/087939 | A1 | 09 May 2019 | US | 2020/0198310 | A1 | |
| | | | | CN | 111295412 | A | |
| | | | | KR | 10-2020-0070217 | A | |
| CN | 112848358 | A | 28 May 2021 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015008260 A
- JP 63259907 A
- JP 2022510017 W
- WO 2020145133 A
- JP 53060979 A
- JP 57000135 A
- JP 61016907 A
- JP 62104816 A
- JP 62190206 A
- JP 63137906 A
- JP 2000143727 A
- JP 2002201217 A
- WO 2007046345 A
- WO 2007119829 A
- WO 2009001894 A
- WO 2010113950 A
- WO 2013027850 A
- JP 60042446 A
- JP 64001711 A
- JP 2261810 A
- JP 11240917 A
- JP 11240918 A
- WO 2003033555 A
- WO 2005061567 A
- WO 2007005361 A
- WO 2011055824 A
- WO 2015080291 A
- WO 2012086710 A
- JP 2005527652 W

### Non-patent literature cited in the description

- **S. WU**. *Polymer Engineering & Science*, 1988, vol. 28, 538
- **S. WU**. *POLYMER ENGINEERING & SCIENCE*, 1989, vol. 29, 273